(19) Europäisches Patentamt
European Patent Office
Office européen des brevets

(11) **EP 4 287 451 A1**

(12) **EUROPEAN PATENT APPLICATION**
published in accordance with Art. 153(4) EPC

(43) Date of publication:
06.12.2023 Bulletin 2023/49

(21) Application number: 22927620.9

(22) Date of filing: 22.03.2022

(51) International Patent Classification (IPC):
*H02J 7/00* (2006.01)      *H01M 10/48* (2006.01)

(52) Cooperative Patent Classification (CPC):
H01M 10/48; H02J 7/00; Y02E 60/10

(86) International application number:
PCT/JP2022/013120

(87) International publication number:
WO 2023/181111 (28.09.2023 Gazette 2023/39)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(71) Applicants:
• KABUSHIKI KAISHA TOSHIBA
Minato-ku
Tokyo 105-0023 (JP)
• Toshiba Energy Systems & Solutions Corporation
Kawasaki-shi, Kanagawa 212-0013 (JP)

(72) Inventors:
• YAMAMOTO, Takahiro
Tokyo, 1050023 (JP)
• MARUCHI, Kohei
Tokyo, 1050023 (JP)
• HATANO, Hisaaki
Tokyo, 1050023 (JP)
• OGURA, Yasuhiro
Yokohama-shi, Kanagawa 2300051 (JP)
• TOBA, Koji
Kawasaki-shi, Kanagawa 2120013 (JP)
• MITSUMOTO, Kenji
Kawasaki-shi, Kanagawa 2120013 (JP)

(74) Representative: Marks & Clerk LLP
15 Fetter Lane
London EC4A 1BW (GB)

(54) **INFORMATION PROCESSING DEVICE, INFORMATION PROCESSING METHOD, INFORMATION PROCESSING SYSTEM, AND COMPUTER PROGRAM**

(57)    [Problem to be solved] there is provided an information processing apparatus, an information processing method, an information processing system, and a computer program for assessing a state of a rechargeable battery.

[Solution] According to one embodiment, an information processing apparatus, includes: an information calculator configured to calculate, based on measured data of a voltage value and a charge amount of a rechargeable battery which is controlled for charge/discharge according to a charge/discharge command value, first information indicating a change of the voltage value with respect to the charge amount; and a state estimator configured to acquire second information indicating a reference change of a voltage value with respect to a charge amount in accordance with a range of the voltage values in the measured data and estimate a state of the rechargeable battery based on the first information and the second information.

FIG. 1

EP 4 287 451 A1

**Description**

[Technical Field]

Embodiments described herein relate to an information processing apparatus, an information processing method, an information processing system, and a computer program.

[Background Art]

A battery energy storage system (BESS) is used for the purpose of improving power quality in a power system or the like. For example, the battery energy storage system is used to stabilize power supplied by the power system or to suppress fluctuations in frequency in the power system. Operating the battery energy storage system over a long period of time necessitates evaluating a state of deterioration (a degree of soundness) of the battery energy storage system. When the battery energy storage system is used in an application for improving power quality of a power system, the battery energy storage system will be basically operational 24 hours a day, 365 days a year. Therefore, an evaluation of the degree of soundness of the battery energy storage system is desirably performed without stopping the operation of the battery energy storage system.

Methods of evaluating the degree of soundness of a battery energy storage system include a method of acquiring, in advance, measured data from the battery energy storage system in operation and creating a database for evaluating the degree of soundness based on the measured data. For example, when an application for suppressing frequency fluctuation in a power system is assumed, deterioration of the battery energy storage system progresses due to cycle charge/discharge in which charge and discharge are repeated over a short period of time. With respect to battery energy storage systems in various stages of progress of deterioration, measured data is acquired from battery energy storage systems in operation, the degree of soundness of the battery energy storage systems is measured, and a database is generated using the measured data and the degree of soundness as training data. A degree of soundness of a battery energy storage system that is an evaluation object can be evaluated using the database.

A battery energy storage system may conceivably be used in an application for adjusting power supply and demand in addition to an application for suppressing frequency fluctuation. In the application for adjusting power supply and demand, for example, when power demand is high, the battery energy storage system is used to discharge power at once and, after discharge is complete, to charge power at once. In this application, the battery energy storage system is kept in a full charge state for a long period of time and storage deterioration or float deterioration progresses according to a length of a period from full charge to start of discharge. Deterioration of a battery cell caused by storage deterioration or float deterioration is often manifested in measured data in a way that differs from cycle deterioration. Therefore, with the method of generating the database described above, the degree of soundness of a battery energy storage system cannot be evaluated.

[Citation List]

[Patent Literature]

[Patent Literature 1] Japanese Patent No. 6313502
[Patent Literature 2] Japanese Patent No. 6759466
[Patent Literature 3] Japanese Publication No. 2020-119712

[Summary of Invention]

[Technical Problem]

The embodiment of the present invention provides an information processing apparatus, an information processing method, an information processing system, and a computer program for assessing a state of a rechargeable battery.

[Solution to Problem]

According to one embodiment, an information processing apparatus, includes: an information calculator configured to calculate, based on measured data of a voltage value and a charge amount of a rechargeable battery which is controlled for charge/discharge according to a charge/discharge command value, first information indicating a change of the voltage value with respect to the charge amount; and a state estimator configured to acquire second information indicating a reference change of a voltage value with respect to a charge amount in accordance with a range of the voltage values in the measured data and estimate a state of the rechargeable battery based on the first information and the second information.

[Brief Description of Drawings]

FIG. 1 is a block diagram of an overall configuration of a rechargeable battery evaluation system as an information processing system according to an embodiment of the present invention;
FIG. 2 is a diagram showing a configuration example of a rechargeable battery;
FIG. 3 is a diagram showing an example of a configuration of a battery module;
FIG. 4 is a diagram showing an example of a charge/discharge information DB;
FIG. 5 is a diagram showing an example of a graph plotting QV data including a SoC and voltage on a coordinate system with an axis of abscissa representing SoC and an axis of ordinate representing voltage;
FIG. 6 is a diagram showing an example of OCV estimated data;
FIG. 7 is a diagram showing voltage distribution information based on measured data acquired in respectively different periods of a rechargeable battery;
FIG. 8 is a diagram showing an example of OCV estimated data calculated from each piece of voltage distribution information shown in FIG. 7;
FIG. 9 is a diagram schematically showing an example of calculating a deterioration feature with respect to the QV plot (voltage distribution information) shown in FIG. 5;
FIG. 10 is a diagram showing an example of a reference DB 16;
FIG. 11 is a diagram for explaining a specific example of processing of estimating a SoH of a rechargeable battery;
FIG. 12 is a flow chart of an example of an operation of a rechargeable battery evaluation apparatus according to the present embodiment;
FIG. 13 is a block diagram of an example of a rechargeable battery evaluation system according to a second modification of the present embodiment;
FIG. 14 is a diagram showing an example of a distribution of charge/discharge command values;
FIG. 15 is a diagram showing an example of a reference DB according to the second modification of the present embodiment; and
FIG. 16 is a diagram showing a hardware configuration example of the rechargeable battery evaluation apparatus according to an embodiment of the present invention.

[Description of Embodiments]

Hereinafter, an embodiment of the present invention will be described with reference to the drawings.

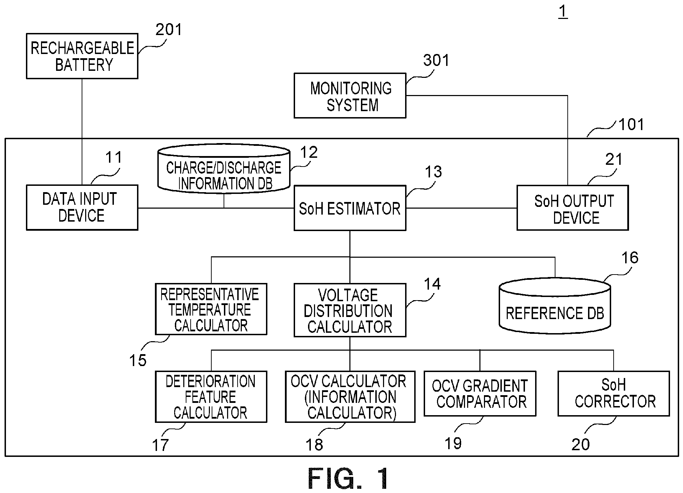

FIG. 1 is a block diagram of an overall configuration of a rechargeable battery evaluation system 1 as an information processing system according to the present embodiment. The rechargeable battery evaluation system 1 shown in FIG. 1 includes a rechargeable battery evaluation apparatus 101 that is the information processing apparatus according to the present embodiment, one or a plurality of rechargeable batteries 201, and a monitoring system 301. The monitoring system 301 is connected to the rechargeable battery evaluation apparatus 101 via a communication network. A given rechargeable battery 201 is connected to another rechargeable battery 201 via a communication network. The communication networks may be a wide area network such as the Internet, a local network such as a wireless LAN, or a wired cable. The rechargeable battery 201 is also called a secondary battery. Hereinafter, names will be unified to "rechargeable battery".
The rechargeable battery 201 is a battery capable of being charged with and discharging electric energy. The rechargeable battery 201 is used by being connected to a power system or a power network such as a VPP (virtual power plant). The rechargeable battery 201 may be directly connected to the power network or connected to the power network in a state of being mounted to a machine such as an EV, an automobile, a rail vehicle, or an industrial device. When connected to a power system, the rechargeable battery 201 is mainly used in an application of suppressing frequency fluctuation in the power system. However, there may be cases where the rechargeable battery 201 is used in a power system in an application of adjusting power supply and demand. On the other hand, when the rechargeable battery 201 is connected to a power network such as a VPP, the rechargeable battery 201 is mainly used in an application of adjusting power supply and demand. However, there may be cases where, after the rechargeable battery 201 is used in an application of suppressing frequency fluctuation, the rechargeable battery 201 is reused in an application of adjusting power supply and demand in a VPP. The rechargeable battery 201 can be used in a variety of other applications.

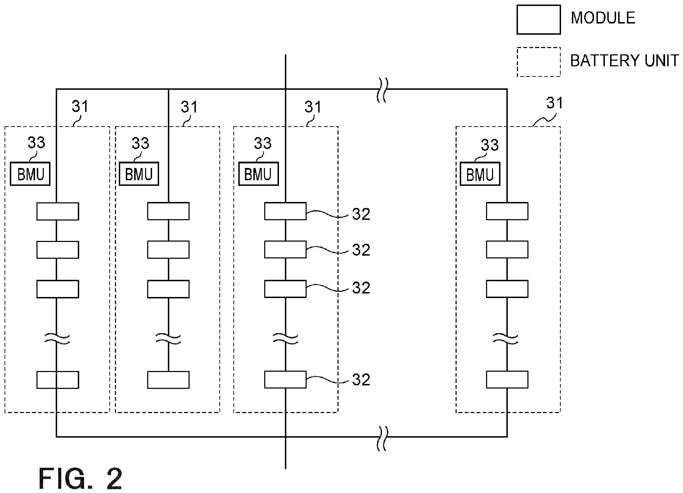

FIG. 2 is a diagram showing a configuration example of the rechargeable battery 201. The rechargeable battery 201 is a battery energy storage system including a battery array in which a plurality of battery units 31 are connected in parallel. In each battery unit 31, a plurality of battery modules 32 are connected in series. Each battery unit 31 includes a BMU (battery management unit) 33. The plurality of battery modules 32 may be connected in parallel or the plurality of battery modules 32 may be connected in series and in parallel. In addition, the plurality of battery units may be connected in series or connected in series and parallel. The BMU 33 may include a communicator which transmits and receives information to and from the rechargeable battery evaluation apparatus 101. The communicator may be arranged inside the battery unit 31 or outside of the battery unit 31.

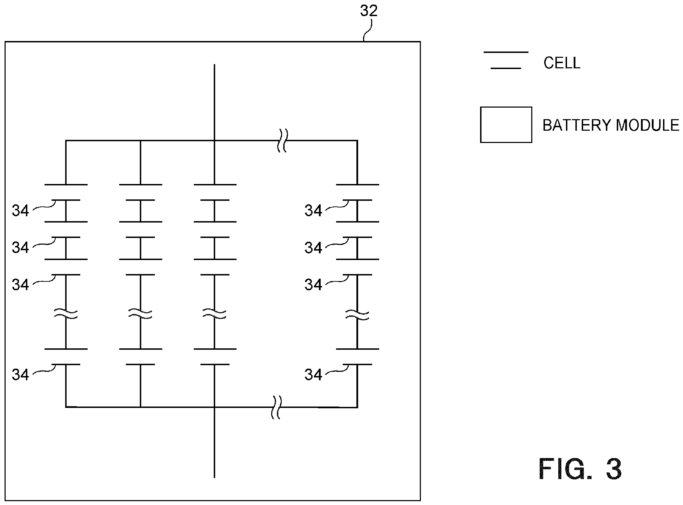

FIG. 3 is a diagram showing an example of a configuration of the battery module 32. The battery module 32 includes a plurality of battery cells (cells) 34 connected in series and in parallel. A configuration in which the plurality of cells 34 are connected in series, a configuration in which the plurality of cells 34 are connected in parallel, or a configuration that combines series and parallel connections can also be adopted. The battery module 32 may include a CMU (cell monitoring unit). The cell 34 is a battery unit capable of charge and discharge. Examples include a lithium-ion battery, a lithium-ion polymer battery, a lead rechargeable battery, a nickel-cadmium battery, and a nickel-hydrogen battery.

A measuring device (not illustrated) for measuring parameters such as voltage, current, temperature, and SoC (state of charge) is arranged with respect to each cell 34. In a similar manner, a measuring device (not illustrated) for measuring parameters such as voltage, current, temperature, and SoC of a battery module is arranged with respect to each battery module 32. In addition, a measuring device (not illustrated) for measuring parameters such as voltage, current, temperature, and SoC of a battery unit is arranged with respect to each battery unit 31. Furthermore, a measuring device (not illustrated) for measuring parameters such as voltage, current, temperature, and SoC (state of charge) of a battery array is arranged with respect to the battery array. While measuring devices that measure voltage, current, temperature, and the like are arranged with respect to every cell, every battery module, every battery unit, and the battery array in this case, measuring devices may only be arranged with respect to some of these types of components. In addition, instead of every cell, the measuring devices may only be arranged with respect to some of the cells, some of the battery modules, and some of the battery units.

A SoC refers to a ratio obtained by dividing a charge amount (amount of electric charge) accumulated in a rechargeable battery by a rated capacity (a full charge capacity of a specification of the rechargeable battery or, in other words, a maximum charge amount before the rechargeable battery starts to deteriorate). While a relative value has been used as the SoC as a value representing a charge amount of the rechargeable battery, a power amount (kWh) actually accumulated in the rechargeable battery 201 may be used as the SoC.

The rechargeable battery 201 sends measured data of the rechargeable battery 201 to the rechargeable battery evaluation apparatus 101. The measured data may include parameters (voltage, current, temperature, and the like) measured by the measuring device and a measurement time of day. As the measurement time of day, a clock may be arranged in the rechargeable battery 201 and a time of day of the clock may be acquired when acquiring the parameters.

The rechargeable battery evaluation apparatus 101 according to the present embodiment evaluates a state of the rechargeable battery 201 to be an evaluation object. Specifically, a degree of soundness (SoH: state of health) or a deterioration state of the rechargeable battery 201 is evaluated. The evaluation of the rechargeable battery 201 or the evaluation of the battery energy storage system as used herein refers to, for example, evaluating an aggregate of all battery cells included in the rechargeable battery 201 and differs from evaluating a measuring device included in the rechargeable battery, evaluating a cell monitoring device, and evaluating a controller. In addition, the evaluation of the rechargeable battery 201 is not limited to evaluating an aggregate of all battery cells and an evaluation can be performed with respect to any level of a hierarchical structure from a single cell to a set made up of a plurality of cells as long as a measured value can be acquired. The rechargeable battery evaluation apparatus 101 according to the present embodiment includes evaluating any battery cell assembly unit such as a cell, a battery module (in reality, an aggregate of cells included in a battery module), and a battery unit (in reality, an aggregate of cells included in a battery unit).

A SoH is an indicator of a deterioration state of a rechargeable battery. A SoH is assumed to be a ratio of a full charge capacity at an evaluation time point to a full charge capacity of a specification of the rechargeable battery. The evaluation time point may be any time point. A method of representing a deterioration state of the rechargeable battery may be discretionally determined. For example, a deterioration state may be defined using a full charge capacity that declines due to deterioration, an internal resistance that increases due to deterioration, or the like.

The rechargeable battery 201 receives a charge/discharge command (at least one of a charge command and a discharge command) from an energy management system of an upper layer and performs charge/discharge with respect to a power system or a power network to which the rechargeable battery 201 is connected. A charge/discharge command is given at, for example, regular intervals. For example, the energy management system of an upper layer manages a plurality of rechargeable batteries in a region, determines a charge/discharge power amount of each rechargeable battery in the region by viewing the plurality of rechargeable batteries in the region as one big battery energy storage system, and sends a charge/discharge command to each rechargeable battery 201 according to time. Each rechargeable battery performs charge/discharge by interpreting and executing the charge/discharge command.

A data input device 11 of the rechargeable battery evaluation apparatus 101 acquires, together with a charge/discharge command value, measured data that is measured for each charge/discharge command from the rechargeable battery 201 that is an evaluation object and stores the acquired measured data and the charge/discharge command value in a charge/discharge information DB 12. The data input device 11 may collectively acquire, from the rechargeable battery 201, measured data and charge/discharge command values of a period that is an object of performing evaluation such as one day, one week, one month, or the like. An acquisition source of measured data is not limited to the rechargeable battery 201 and, when there is a management server that collects and manages measured data of the rechargeable battery 201, the measured data of the rechargeable battery 201 may be acquired from the management server. In addition, the data input device 11 may acquire the charge/discharge command value executed by the rechargeable battery 201 from the energy management system described above. Note that the acquisition of measured data in the rechargeable battery 201 need not be performed for every execution of a charge/discharge command and, for example, measured data may be acquired several times during a period between executions of two consecutive charge/discharge commands or measured data may be acquired once each time a plurality of charge/discharge commands are executed.

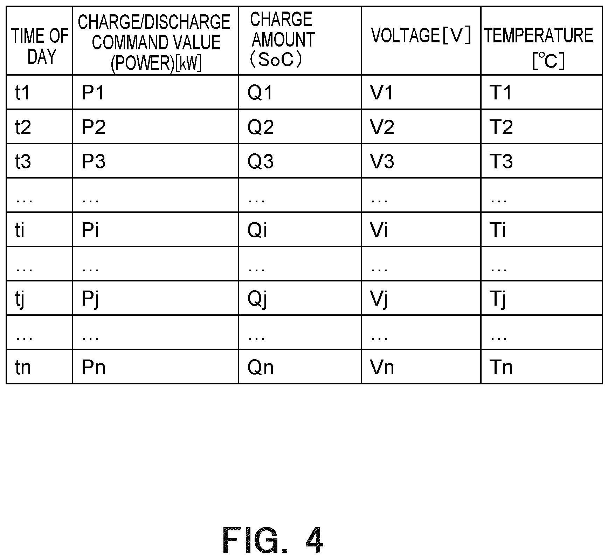

FIG. 4 shows an example of the charge/discharge information DB 12. Charge/discharge data including a time of day, a charge/discharge command value, a charge amount, and voltage and temperature is stored in a time series. Times of day t1 to tn correspond to charge/discharge command times of day or measurement times of day. The items shown in FIG. 4 are merely an example and items not shown (such as a current or humidity) may be added or a part of the items shown (for example, temperature) may be omitted.

P1, P2, ..., Pn denote power values indicated by charge/discharge command values at times of day t1 to tn. Px denotes a power value indicated by the charge/discharge command value at a time of day tx. P1, ..., Pn are signed numerical values. As an example, while it is assumed that a positive value represents discharge and a negative value represents charge, the opposite may apply. A power value may be calculated based on a current and a voltage measured from the rechargeable battery 201 instead of a power value indicated by a charge/discharge command value.

Q1, Q2, ..., Qn denote charge amounts (SoC) of the rechargeable battery 201 at the times of day t1 to tn. Qx denotes a SoC of the rechargeable battery 201 at the time of day tx. A SoC refers to a ratio obtained by dividing a charge amount (amount of electric charge) accumulated in the rechargeable battery 201 by a rated capacity. While a SoC that is a relative value has been used as a value representing a charge amount of the rechargeable battery 201, a power amount (kWh) actually accumulated in the rechargeable battery 201 may be used instead. When information on a SoC of the rechargeable battery 201 cannot be directly acquired, a SoC may be calculated by accumulating current values.

T1, T2, ..., Tn represent temperatures of the rechargeable battery 201 at the times of day t1 to tn. Tx denotes a temperature of the rechargeable battery 201 at the time of day tx.

The charge/discharge data at the time of day t1 in FIG. 4 includes a charge/discharge command value P1, a charge amount (SoC) Q1, a voltage V1, and a temperature T1. This means that charge/discharge of the charge/discharge command value P1 is executed at the time of day t1 under a charge voltage or a discharge voltage of the voltage V1 and, as a result, the SoC of the rechargeable battery 201 becomes Q1 and the temperature of the rechargeable battery 201 at that time is T1. Measured data at the times of day t2 to tn is interpreted in a similar manner.

A representative temperature calculator 15 calculates a representative temperature of the rechargeable battery 201 based on measured data of the rechargeable battery 201 during an evaluation object period. For example, an average of temperatures of the rechargeable battery 201 included in the measured data is adopted as the representative temperature. A temperature at which a dwell time of the rechargeable battery 201 is longest or a temperature equal to or higher than a threshold in the evaluation object period may be adopted as the representative temperature. Alternatively, the representative temperature may be determined by other methods.

A voltage distribution calculator 14 calculates voltage distribution information using a voltage and a SoC in a plurality of pieces of measured data included in the evaluation object period of the rechargeable battery 201. Specifically, the voltage distribution calculator 14 plots data (QV data) including a voltage and a SoC in measured data during a measurement period in the charge/discharge information DB 12 on a coordinate system with an axis of abscissa representing SoC and an axis of ordinate representing voltage. Accordingly, voltage distribution information representing a distribution of voltage with respect to SoC is obtained.

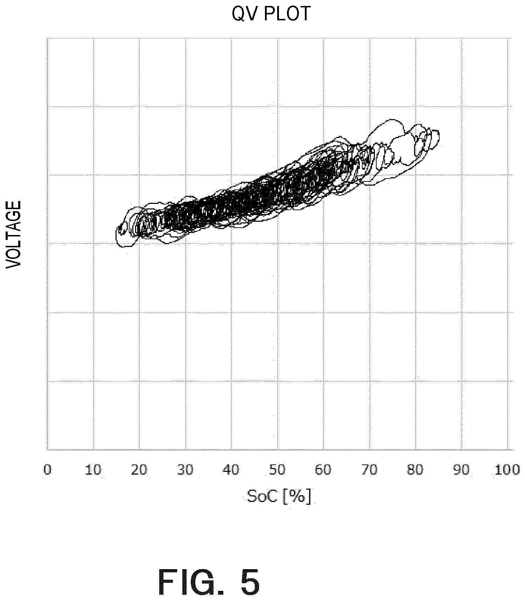

FIG. 5 shows an example of a graph plotting QV data including a SoC and a voltage on a coordinate system with an axis of abscissa representing SoC and an axis of ordinate representing voltage. Plotted dots are connected by lines in a time series. The data in FIG. 5 is also referred to as a QV plot. In this example, charge and discharge are repeated many times (for example, a cycle charge) and a complex curve that goes back and forth between a low SoC and a high SoC is obtained. As an example, the measurement period is one day and, in this case, data necessary for a plot is one day's worth of data. However, the measurement period may be a shorter period of time than a day (24 hours) or may be two days or longer, one week, one month, or the like.

An OCV calculator 18 estimates an open circuit voltage (OCV) of the rechargeable battery 201 based on the voltage distribution information. In other words, the OCV calculator 18 generates an OCV in a simulated manner. An OCV is a voltage of the rechargeable battery 201 in a state where the rechargeable battery 201 is not energized (voltage is not applied or a current does not flow).

Estimation of an OCV can be performed by, for example, calculating a moving average of voltage (V) with respect to SoC. Specifically, pieces of data (QV data) of a set of a SoC and a voltage are sorted in an order of SoC. In other words, the pieces of data are arranged in an ascending order of SoC. A moving average of voltages is calculated with respect to SoC based on the sorted data. Accordingly, moving average data of a voltage value with respect to SoC is obtained. The moving average data is estimated data of OCV (OCV estimated data or OCV graph). An OCV estimated by this method may be described a generated OCV, data of a set of a generated OCV and a SoC may be described generated OCV data, and a plot of the generated OCV data on a QV coordinate system may be described a QV plot (generated OCV). An estimation method of an OCV may be another method. For example, a graph of a regression of voltage due to SoC may be generated by regression analysis and the generated graph may be adopted as an OCV graph. There are various other methods of estimating an OCV. In addition, OCV estimated data or an OCV graph is an example of a function or a graph that represents a relationship between a charge amount and a voltage value and another function or a graph may be adopted as long as the function or the graph is capable of indicating the relationship. The following description assumes a case where estimation of an OCV is performed by calculating a moving average of voltage (V) with respect to SoC.

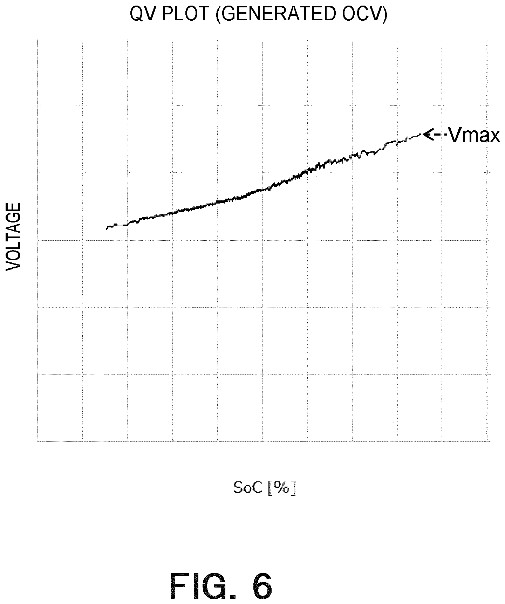

FIG. 6 shows an example of a QV plot (generated OCV) as OCV estimated data. The graph (OCV graph) represents an estimated value of OCV (generated OCV) with respect to SoC and, in the present example in which the graph is also described as a generated OCV graph, a right end of the graph corresponds to a maximum voltage and a maximum SoC of the generated OCV. A left end of the graph corresponds to a minimum voltage and a minimum SoC of the generated OCV.

When float deterioration or storage deterioration of a rechargeable battery progresses, a gradient of the generated OCV graph increases. While the gradient of the generated OCV graph also increases when cycle deterioration progresses, in the case of cycle deterioration, a change in a range of voltage (for example, a standard deviation of voltage) in a voltage distribution is more dominant. Note that cycle deterioration mainly appears as a change in internal resistance (increase in internal resistance) and a change in a gradient (increase in the gradient) of generated OCV and both changes lead to a drop in battery capacity. Storage deterioration and float deterioration almost entirely appear as a change in the gradient of generated OCV. A comparison between storage deterioration and float deterioration shows that a rate of change of the gradient is larger in the case of float deterioration (deterioration progresses faster).

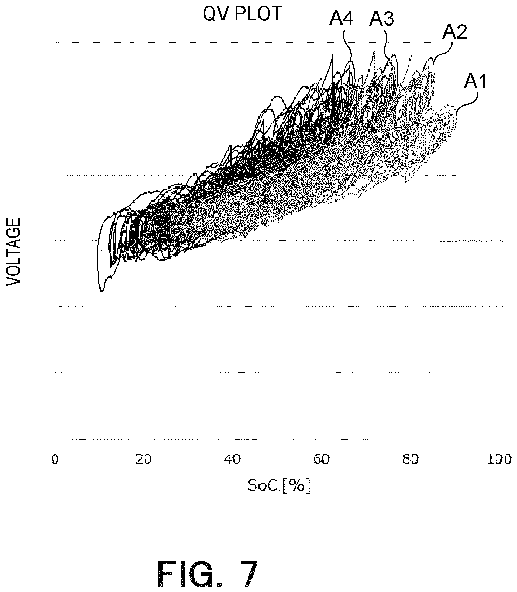

An example in which the gradient of an OCV graph increases when float deterioration or storage deterioration of a rechargeable battery progresses will be shown with reference to FIG. 7.

FIG. 7 shows voltage distribution information generated based on measured data acquired in respectively different periods of a rechargeable battery. Voltage distribution information A1 is measured during a period with the least degree of progress of deterioration, and deterioration progresses in an order of pieces of voltage distribution information A2, A3, and A4. Float deterioration or storage deterioration is mainly assumed as the deterioration in this case.

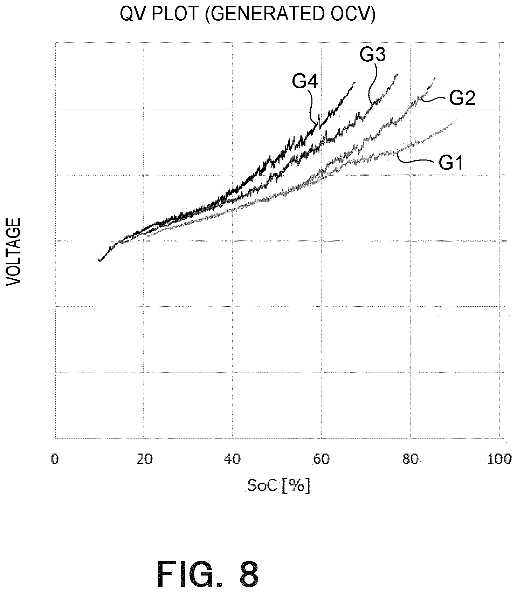

FIG. 8 shows an example of pieces of OCV estimated data (QV plots (generated OCV)) G1 to G4 calculated from pieces of voltage distribution information (QV plots) A1 to A4 shown in FIG. 7. OCV estimated data G1 is measured during a period with the least degree of progress of deterioration, and deterioration progresses in an order of pieces of OCV estimated data G2, G3, and G4. The further deterioration progresses, the larger the gradient of generated OCV. In other words, the further deterioration progresses, the narrower a range (SoC width) between a minimum SoC and a maximum SoC of OCV estimated data (generated OCV graph).

The OCV calculator 18 calculates a gradient of OCV estimated data (OCV graph) and a size of a SoC range (a difference between a maximum SoC and a minimum SoC). The gradient of OCV estimated data corresponds to an example of the first information indicating a change in a voltage value with respect to a charge amount in measured data of the rechargeable battery 201. A SoC range corresponds to a range of the charge amount in measured data of the rechargeable battery 201.

A SoC range corresponds to a portion between the minimum SoC and the maximum SoC. The minimum SoC may be a SoC corresponding to a minimum generated OCV in OCV estimated data. The maximum SoC may be a SoC corresponding to a maximum generated OCV in OCV estimated data.

A gradient of OCV estimated data can be calculated as a gradient of a straight line that approximates a generated OCV graph. As an example, a straight line that minimizes square error with a generated OCV graph or causes the square error to be equal to or smaller than a threshold can be calculated by a least squares method and a gradient of the calculated straight line can be adopted as the gradient of OCV estimated data. Alternatively, a gradient of a straight line that connects both ends of a generated OCV graph may be adopted as a gradient of OCV estimated data. Alternatively, a position (coordinate) corresponding to a predetermined SoC in a generated OCV graph may be specified and a tangent at the specified position may be adopted as a gradient of OCV estimated data. While the gradient of a generated OCV graph is calculated as a change of a voltage value with respect to a charge amount, other methods may be used as long as the change can be calculated. For example, a straight line that approximates voltage distribution information (QV plot) may be calculated and the gradient of the straight line may be adopted as the first information indicating a change of a voltage value with respect to a charge amount. Alternatively, a function or a graph representing a relationship between a charge amount and a voltage value may be generated and a gradient of the function or the graph may be calculated as the first information.

A deterioration feature calculator 17 calculates a feature (deterioration feature) regarding a range (spread) of voltage based on voltage distribution information. An example of a deterioration feature is a standard deviation of voltage. The calculation of a standard deviation may be performed with a total SoC range in the voltage distribution information as an object or a predetermined SoC range in the voltage distribution information as an object. Since a SoC range with a strong association with SoH may change according to the temperature of the rechargeable battery 201, a SoC range that is an object may be made variable according to the representative temperature of the rechargeable battery 201.

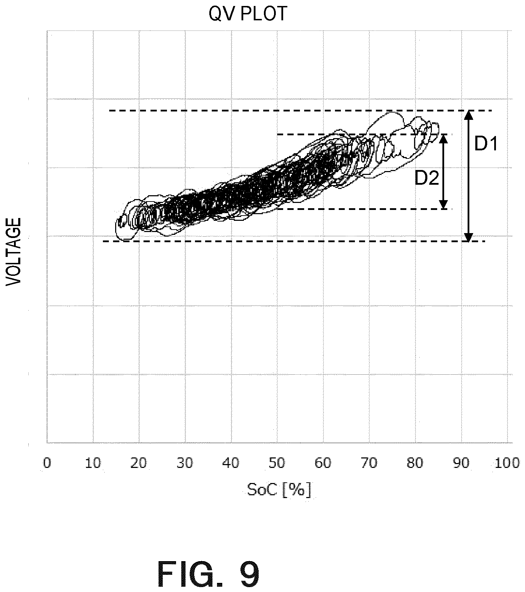

FIG. 9 schematically shows an example of calculating a deterioration feature with respect to the QV plot (voltage distribution information) shown in FIG. 5. For example, when a total SoC range is an object, a standard deviation of voltage is calculated with respect to voltage values included in a voltage range D1. When a range of SoC 50 to 60% is an object, a standard deviation is calculated with respect to voltage values included in a voltage range D2.

Examples of a deterioration feature other than a standard deviation include an absolute value of a difference between a maximum voltage and a minimum voltage. A SoC range to be an object of calculating an absolute value may be determined in a similar manner to the case of a standard deviation. In this case, a maximum voltage and a minimum voltage are specified within the determined SoC range and an absolute value of the difference between the maximum voltage and the minimum voltage is calculated.

A reference DB 16 includes reference data related to one or a plurality of rechargeable batteries (sample rechargeable batteries) that have deteriorated due to performing charge/discharge in the past. The reference data is used as training data when estimating a SoH of the rechargeable battery 201 to be an evaluation object. A case where cycle deterioration of the sample rechargeable battery is performed by mainly performing cycle charge/discharge as charge/discharge will be assumed. A case where storage deterioration and float deterioration of the sample rechargeable battery is absent or is sufficiently less than cycle deterioration will be assumed.

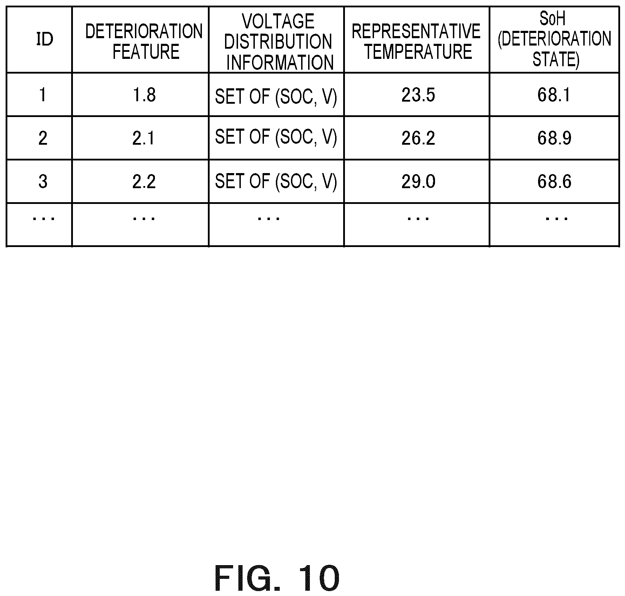

FIG. 10 shows an example of the reference DB 16. Reference data includes an ID of the data, a deterioration feature, voltage distribution information, and a SoH (reference SoH). The voltage distribution information is similar to the voltage distribution information explained in the rechargeable battery 201 described earlier. The deterioration feature is calculated from the voltage distribution information of the sample rechargeable battery. Each piece of reference data may be obtained from one sample rechargeable battery or obtained from a plurality of rechargeable batteries. The reference data may include information (battery ID) that identifies the sample rechargeable battery. In the reference DB 16, a plurality of SoH (reference SoH) are associated with a plurality of ranges (for example, voltage distribution information) of voltage values.

A SoH estimator 13 specifies reference data to be used in deterioration evaluation (SoH evaluation) of the rechargeable battery 201 from the reference DB 16 in accordance with a range of voltage values in the measured data of the rechargeable battery 201. Specifically, the SoH estimator 13 specifies reference data to be used in deterioration evaluation (SoH evaluation) of the rechargeable battery 201 from the reference DB 16 based on the deterioration feature of the rechargeable battery 201. For example, reference data with a deterioration feature that is consistent with or closest to the deterioration feature of the rechargeable battery 201 is specified in the reference DB 16. Being "closest to" means that an absolute value of a difference is minimized.

Alternatively, the SoH estimator 13 may specify, in the reference DB 16, reference data with voltage distribution information that is consistent with or with a shortest distance to the voltage distribution information of the rechargeable battery 201. As a distance between distributions, for example, a Kullback-Leibler distance, a Pearson distance, or a relative Pearson distance can be used.

The SoH estimator 13 may specify reference data to be used in deterioration evaluation based on both a deterioration feature (or voltage distribution information) and a representative temperature. As an example, the SoH estimator 13 acquires a plurality of pieces of reference data with a matching representative temperature and specifies reference data with a deterioration feature that is consistent with or closest to the deterioration feature of the rechargeable battery 201 from among the plurality of pieces of reference data.

Hereinafter, the specified reference data may also be referred to as object reference data. A SoH (reference SoH) in the object reference data corresponds to a state (reference state) to be reference during which the rechargeable battery 201 is mainly only subjected to cycle deterioration.

The SoH estimator 13 sends, to the OCV calculator 18, instruction data that instructs the OCV calculator 18 to perform estimation of an OCV based on the voltage distribution information in the specified reference data (object reference data). In accordance with the instruction data, the OCV calculator 18 estimates an OCV based on the voltage distribution information of the object reference data and obtains OCV estimated data (generated OCV graph) from data (generated OCV data) of a set of a SoC and a generated OCV. Estimation of an OCV may be performed in advance to generate OCV estimated data and the OCV estimated data may be stored in the reference DB 16 as a part of reference data. In this case, the SoH estimator 13 may acquire OCV estimated data included in the object reference data from the reference DB 16. The OCV calculator 18 calculates a gradient of OCV estimated data. The gradient of OCV estimated data may be stored in advance in the reference DB 16 as a part of reference data.

The gradient of OCV estimated data that is estimated based on the voltage distribution information in the object reference data corresponds to the second information representing a reference change of a voltage value with respect to a charge amount. In this manner, the SoH estimator 13 acquires the second information (in the present example, the gradient of OCV estimated data) that represents a reference change of a voltage value with respect to a charge amount in accordance with a range of voltage values of the rechargeable battery 201. A method of acquisition may be any of a method of estimating OCV estimated data based on the voltage distribution information in the object reference data and acquiring a gradient of the OCV estimated data and a method of storing a gradient in the reference DB 16 in advance and reading the gradient. In either method, a plurality of pieces of the second information are associated with a plurality of ranges of voltage values in advance and second information that corresponds to the range of voltage values in the measured data of the rechargeable battery 201 is acquired.

An OCV gradient comparator 19 compares a generated OCV gradient (referred to as an object OCV gradient) calculated based on the OCV estimated data of the rechargeable battery 201 and a generated OCV gradient (referred to as a reference OCV gradient) calculated based on the object reference data with each other. The OCV gradient comparator 19 provides the SoH estimator 13 with information indicating a result of the comparison. The object OCV gradient corresponds to a change indicated by the first information based on the measured data of the rechargeable battery 201 and the reference OCV gradient corresponds to a change indicated by the second information based on the object reference data.

When the object OCV gradient and the reference OCV gradient are consistent with each other or a difference between the object OCV gradient and the reference OCV gradient is smaller than a threshold, the SoH estimator 13 determines that the SoH included in the object reference data need not be corrected. In other words, in this case, it is assumed that float deterioration or storage deterioration of the rechargeable battery 201 has not occurred or has hardly occurred. The SoH estimator 13 adopts a SoH (reference SoH) included in the object reference data as a SoH of the rechargeable battery 201. The reference SoH in the object reference data corresponds to a reference state of the rechargeable battery 201 (a state during which the rechargeable battery 201 is not subjected to cycle deterioration).

When the difference between the object OCV gradient and the reference OCV gradient is equal to or larger than a threshold, the SoH estimator 13 determines that the SoH (reference SoH) included in the object reference data needs to be corrected. In other words, in this case, even when the cycle deterioration of the rechargeable battery 201 is the same or comparable with the cycle deterioration of the sample rechargeable battery in the object reference data, unlike the sample rechargeable battery, float deterioration or storage deterioration is interpreted to have occurred in the rechargeable battery 201. The SoH estimator 13 determines that the larger the difference between the object OCV gradient and the reference OCV gradient, the more progressed at least one of float deterioration and storage deterioration is. Since a SoH (reference SoH) stored in the reference DB 16 is a SoH of the sample rechargeable battery that is assumed to only have cycle deterioration, a SoH included in object reference data must be corrected in order to obtain a SoH that also takes float deterioration or storage deterioration of the sample rechargeable battery into consideration. In this manner, the SoH estimator 13 acquires a reference SoH (a SoH in object reference data) corresponding to a range in voltage values in the measured data of the rechargeable battery 201 as a reference state of the rechargeable battery 201 and makes a determination to correct the acquired reference SoH (correct information indicated by the reference state).

A SoH corrector 20 corrects the SoH (reference SoH) included in the object reference data based on the voltage distribution information (referred to as object voltage distribution information) of the rechargeable battery 201 and voltage distribution information (referred to as reference voltage distribution information) included in the object reference data. Specifically, a maximum SoC and a minimum SoC are specified based on the object voltage distribution information and a difference (described as $\Delta SoC\_e$) between the maximum SoC and the minimum SoC or, in other words, a SoC width is calculated. In addition, a maximum SoC and a minimum SoC are specified based on the reference voltage distribution information and a difference (described as $\Delta SoC\_r$) between the maximum SoC and the minimum SoC or, in other words, a SoC width is calculated. $\Delta SoC\_r$ may be stored in advance in the reference DB 16 as a part of reference data. In this case, the SoH corrector 20 may acquire the difference $\Delta SoC\_r$ included in the object reference data from the reference DB 16.

The SoH corrector 20 corrects the reference SoH by multiplying the SoH (reference SoH) included in the object reference data by a ratio (or a difference) between $\Delta SoC\_e$ and $\Delta SoC\_r$. In other words, information indicating a reference state of the rechargeable battery 201 is corrected in accordance with a ratio (or a difference) between $\Delta SoC\_e$ and $\Delta SoC\_r$. Accordingly, a SoH of the rechargeable battery 201 is obtained. A calculation formula is shown in expression (1) below.

$$SoH\_e = (\Delta SoC\_e / \Delta SoC\_r) * SoH\_r \quad (1)$$

SoH_r denotes the SoH included in object reference data (reference state of rechargeable battery 201). SoH_e denotes the SoH after correction or, in other words, the estimated SoH of the rechargeable battery 201.

In this manner, the SoH estimator 13 corrects information indicating a reference state of the rechargeable battery 201 in accordance with a ratio (or a difference) between the first information ($\Delta SoC\_e$) and the second information ($\Delta SoC\_r$). The SoH estimator 13 determines the state (estimated SoH) of the rechargeable battery 201 based on the corrected information.

The SoH estimator 13 provides a SoH output device 21 with evaluation result information of the rechargeable battery 201 based on an estimated SoH of the rechargeable battery 201 (the SoH after correction when correction of the SoH is performed or the reference SoH included in object reference data when correction of the SoH is not performed). As an example, the evaluation result information includes a value of the SoH and detailed information of the rechargeable battery 201. The detailed information may include a battery ID and voltage, temperature, power, and a distribution of temperature or the like. The distribution may be generated based on the measured data used in the evaluation.

The SoH output device 21 transmits the evaluation result information of the rechargeable battery 201 to the monitoring system 301. The SoH output device 21 may diagnose whether or not the rechargeable battery 201 is normal based on a value of the SoH. For example, the rechargeable battery 201 is determined to be normal when the SoH is equal to or higher than a threshold A, determined to require maintenance when the SoH is lower than the threshold A but equal to or higher than a threshold B, and determined to be abnormal (needs to be replaced) when the SoH is lower than the threshold B. The SoH output device 21 may include a diagnosis result in the evaluation result information.

Based on the evaluation result information received from the SoH output device 21, the monitoring system 301 displays a screen (deterioration state evaluation screen) for evaluating the deterioration state of the rechargeable battery 201 on a display with respect to a monitor. In addition, when a diagnosis result is included in the evaluation result information, an operation in accordance with the diagnosis result may be performed. For example, when the diagnosis result indicates an abnormality, a message of a failure alert may be displayed on the screen. When maintenance of the rechargeable battery 201 is necessary, a message regarding a maintenance call may be displayed on the screen. When the rechargeable battery 201 is normal, a message describing that the rechargeable battery 201 is normal may be displayed on the screen. In addition to displaying on the screen, a message sound notifying a failure alert, a maintenance call, or a normal state of the rechargeable battery 201 may be outputted via a speaker.

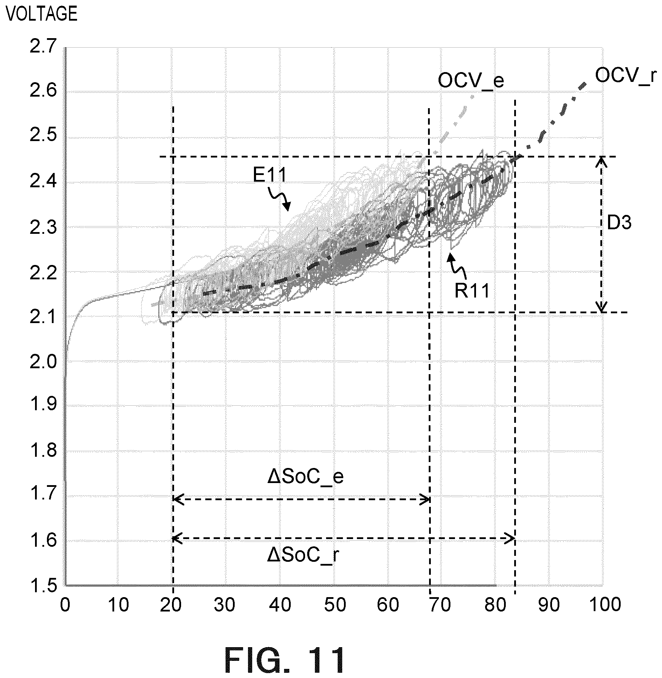

FIG. 11 is a diagram for explaining a specific example of processing of estimating a SoH of the rechargeable battery 201. Voltage distribution information (QV plot) E11 of the rechargeable battery 201 and voltage distribution information (QV plot) R11 included in the object reference data are shown. In other words, the SoH estimator 13 specifies reference data including a deterioration feature that most closely approximates the deterioration feature calculated from the voltage distribution information E11 from the reference DB 16, in which case the voltage distribution information included in the specified reference data (object reference data) is the voltage distribution information R11.

The OCV calculator 18 generates OCV estimated data (OCV_e) based on the voltage distribution information E11 and generates OCV estimated data (OCV_r) based on the voltage distribution information R11. The OCV calculator 18 calculates a gradient of OCV_e and a gradient of OCV_r.

The OCV gradient comparator 19 compares the gradient of OCV_e and the gradient of OCV_r with each other and determines whether or not a difference between the gradients is equal to or larger than a threshold. In the present example, the difference is determined to be equal to or larger than the threshold. In other words, a determination that correction in accordance with the difference is necessary is made with respect to the SoH (reference SoH) included in the object reference data.

The SoH corrector 20 calculates a difference $\Delta SoC\_e$ between the maximum SoC and the minimum SoC based on the voltage distribution information E11. The SoH corrector 20 calculates a difference $\Delta SoC\_r$ between the maximum SoC and the minimum SoC based on the voltage distribution information R11. Based on expression (1) described above, the SoH corrector 20 calculates a SoH (SoH_e) of the rechargeable battery by multiplying the SoH (SoH_r) included in the object reference data by $\Delta SoC\_e / \Delta SoC\_r$.

As described earlier with reference to FIGS. 7 and 8, when float deterioration or storage deterioration progresses, the gradient of the generated OCV graph increases and, accordingly, a width between a maximum value and a minimum value of a SoC narrows (a difference between the maximum value and the minimum value decreases). Therefore, how much float deterioration or storage deterioration of the rechargeable battery 201 has progressed as compared to the sample rechargeable battery can be evaluated based on a ratio of the difference $\Delta SoC\_e$ between the maximum SoC and the minimum SoC of the rechargeable battery 201 to the difference $\Delta SoC\_r$ between the maximum SoC and the minimum SoC of the sample rechargeable battery without float deterioration and storage deterioration. Consequently, by using reference data including a SoH of cycle deterioration as training data, a SoH of a rechargeable battery in which float deterioration and storage deterioration have progressed can be evaluated even without training data related to a SoH of float deterioration and storage deterioration.

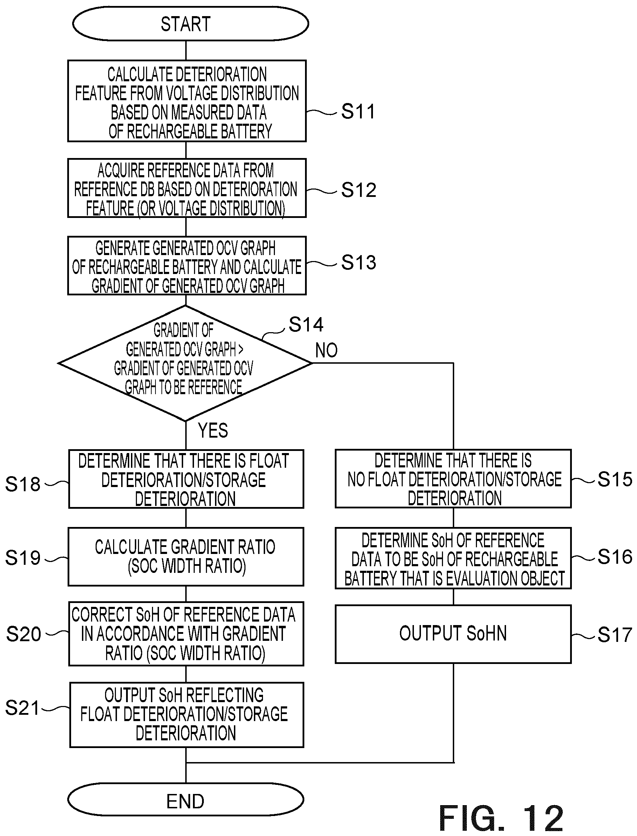

FIG. 12 is a flow chart of an example of an operation of the rechargeable battery evaluation apparatus 101 according to the present embodiment. The data input device 11 acquires measured data (voltage, charge amount (SoC), temperature, humidity, and the like) from the rechargeable battery 201 at, for example, regular intervals in advance and stores the acquired measured data in the charge/discharge information DB 12.

In step S11, the SoH estimator 13 acquires measured data in an evaluation object period with respect to the rechargeable battery 201 to be an evaluation object from the charge/discharge information DB12 and provides the voltage distribution calculator 14 with the acquired measured data. The voltage distribution calculator 14 generates voltage distribution information (QV plot) based on data of a voltage value and a SoC (QV data) included in the measured data. The deterioration feature calculator 17 calculates a deterioration feature based on the voltage distribution information.

In step S12, the SoH estimator 13 specifies reference data including a deterioration feature that is consistent with or close to the calculated deterioration feature from the reference DB 16. Alternatively, the SoH estimator 13 may specify, from the reference DB 16, reference data including voltage distribution information that is consistent with or close to the generated voltage distribution information.

In step S13, the OCV calculator 18 estimates an OCV of the rechargeable battery 201 based on the generated voltage distribution information (QV plot) and generates OCV estimated data (object OCV estimated data) of the rechargeable battery 201. In addition, the OCV calculator 18 calculates a gradient (object OCV gradient) of the object OCV estimated data. Furthermore, the OCV calculator 18 estimates an OCV of the sample rechargeable battery based on the voltage distribution information (QV plot) included in the specified reference data (object reference data) and generates OCV estimated data (reference OCV estimated data) of the sample rechargeable battery. In addition, the OCV calculator 18 calculates a gradient (reference OCV gradient) of the reference OCV estimated data.

In step S14, the OCV gradient comparator 19 compares the object OCV gradient and the reference OCV gradient with each other and determines whether or not a difference between the gradients is equal to or smaller than a threshold. When the difference between the gradients is equal to or smaller than the threshold, the operation advances to step S15, but when the difference between the gradients is larger than the threshold, the operation advances to step S18. As an example, the threshold may be zero. In this case, step S14 corresponds to determining whether or not the object OCV gradient is larger than the reference OCV gradient. When the object OCV gradient is equal to or smaller than the reference OCV gradient, the operation advances to step S15, but when the object OCV gradient is larger than the reference OCV gradient, the operation advances to step S18.

In step S15, the SoH estimator 13 determines that float deterioration or storage deterioration is absent or minimal in the rechargeable battery 201.

In step S16, the SoH estimator 13 adopts a SoH (reference SoH) included in the object reference data as a SoH of the rechargeable battery 201. Accordingly, the SoH of the rechargeable battery 201 in which float deterioration and storage deterioration is absent or has hardly progressed is estimated.

In step S17, the SoH output device 21 generates evaluation result information of the rechargeable battery 201 based on the estimated SoH of the rechargeable battery 201 and transmits the generated evaluation result information to the monitoring system 301.

In step S18, the SoH estimator 13 determines that at least one of float deterioration and storage deterioration is present in the rechargeable battery 201.

In step S19, the SoH corrector 20 calculates a size of a SoC range based on the voltage distribution information in the object reference data. In other words, the SoH corrector 20 calculates a difference ($\Delta SoC\_r$) between a maximum SoC and a minimum SoC. The size (difference) of the SoC range may be stored in advance in the reference DB 16 as a part of reference data and, in this case, the SoH corrector 20 may acquire the size (difference) of the SoC range from the object reference data. In a similar manner, the SoH estimator 13 calculates a size of a SoC range based on the voltage distribution information of the rechargeable battery 201. In other words, the SoH estimator 20 calculates a difference ($\Delta SoC\_e$) between the maximum SoC and the minimum SoC. The SoH corrector 20 corrects the SoH by multiplying a ratio between $\Delta SoC\_e$ and $\Delta SoC\_r$ by the SoH (reference SoH) included in the object reference data. The corrected SoH is adopted as an estimated SoH of the rechargeable battery 201. Accordingly, the SoH of the rechargeable battery 201 in which at least one of float deterioration and storage deterioration has progressed is estimated with high accuracy.

In step S20, the SoH output device 21 generates evaluation result information of the rechargeable battery 201 based on the estimated SoH of the rechargeable battery 201 and transmits the generated evaluation result information to the monitoring system 301.

As described above, according to the present embodiment, data of sample rechargeable batteries of various SoH in which cycle deterioration has progressed is prepared as training data. When a gradient of OCV estimated data of a rechargeable battery that is an evaluation object is larger than a gradient of OCV estimated data in the training data, a determination that float deterioration or storage deterioration has progressed is made. In addition, a SoH in the training data is corrected in accordance with a ratio or a difference between a size of a SoC range of voltage distribution information in the rechargeable battery and a size of a SoC range of voltage distribution information in the sample rechargeable battery. Alternatively, the SoH in the training data is corrected in accordance with a difference between the gradients of the OCV estimated data. Accordingly, a SoH of the rechargeable battery can be estimated including float deterioration and storage deterioration of the rechargeable battery without having to prepare training data that reflects the float deterioration or the storage deterioration. The SoH of the rechargeable battery can be readily and correctly evaluated even when data of sample rechargeable batteries of various SoH in which float deterioration or storage deterioration has progressed cannot be prepared as training data.

(First modification)

In the embodiment described above, a SoH (reference SoH) included in reference data specified from the reference DB 16 is used as a SoH (SoH that only assumes cycle deterioration) prior to correction of the rechargeable battery 201. As a modification, the SoH prior to correction of the rechargeable battery 201 may be calculated based on an evaluation function from a deterioration feature of the rechargeable battery 201.

For example, the reference DB 16 stores, in advance, an evaluation function that calculates a SoH from a deterioration feature. The evaluation function may be generated based on reference data stored in the reference DB 16. While a form of the evaluation function is not limited to a specific form, as an example, there is an evaluation function in the form of a linear function $y = a \times x + b$. Reference characters a and b denote coefficients, an input variable x represents a deterioration feature, and an output variable represents a SoH. An input variable z of a representative temperature may be added to a same term as the input variable x or a different term from the input variable x in the evaluation function. Alternatively, a different evaluation function may be created for each representative temperature.

The deterioration feature calculator 17 calculates a SoH prior to correction by inputting the deterioration feature of the rechargeable battery 201 into the input variable x of the evaluation function. Alternatively, the deterioration feature calculator 17 calculates a SoH prior to correction by inputting the deterioration feature of the rechargeable battery 201 into the input variable x of the evaluation function and inputting a representative temperature of the rechargeable battery 201 to the variable z.

According to the present modification, by calculating the SoH prior to correction using an evaluation function, it is expected that the SoH prior to correction (SoH that only assumes cycle deterioration) can be calculated with high accuracy.

(Second modification)

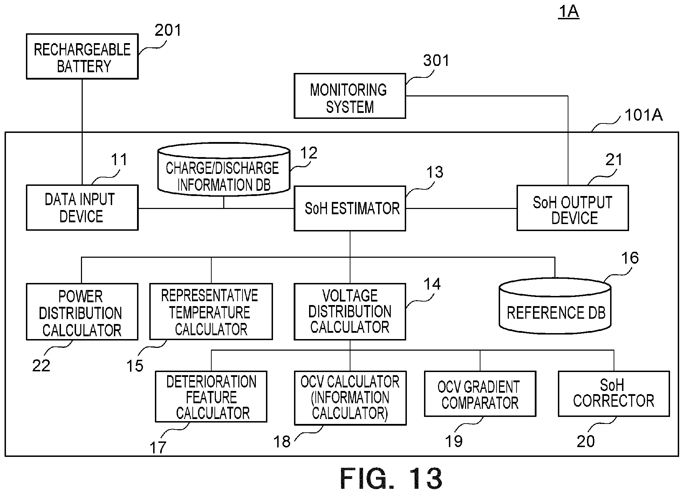

FIG. 13 is a block diagram of an example of a rechargeable battery evaluation system 1A according to a second modification. A rechargeable battery evaluation apparatus 101A is provided with a power distribution calculator 22 (charge/discharge command value calculator).

The power distribution calculator 22 calculates a distribution of charge/discharge command values based on charge/discharge command values included in measured data of an evaluation object period in the charge/discharge information DB 12. For example, a distribution with charge/discharge command values as an axis of abscissa and frequency (or probability density) as an axis of ordinate is calculated. Assuming that the distribution of charge/discharge command values is a normal distribution, parameters of a normal distribution that approximates the distribution may be calculated.

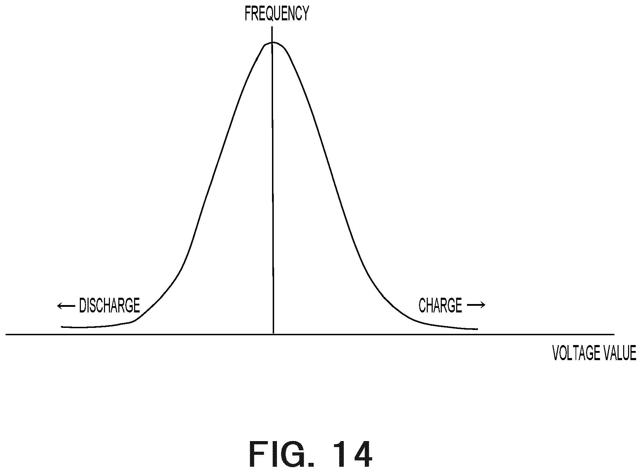

FIG. 14 shows an example of a distribution of charge/discharge command values. An axis of abscissa represents charge/discharge command values (power values commanded by charge/discharge command values) and an axis of ordinate represents frequency.

Each piece of reference data in the reference DB 16 stores a distribution of charge/discharge command values of the sample rechargeable battery. The distribution of charge/discharge command values included in reference data will be referred to as a reference distribution of charge/discharge command values.

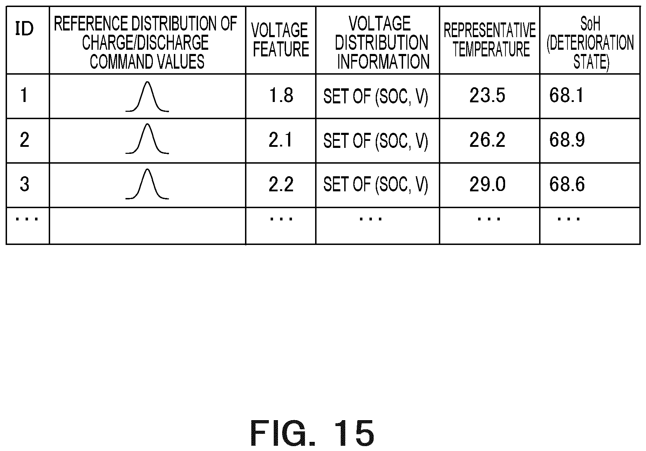

FIG. 15 shows an example of the reference DB 16 according to the second modification. A reference distribution of charge/discharge command values is stored.

When specifying reference data from the reference DB 16, the SoH estimator 13 uses the calculated distribution of charge/discharge command values in addition to power distribution information (or a deterioration feature). As an example, the SoH estimator 13 detects one or more pieces of reference data based on a distance between the distribution of charge/discharge command values and the reference distribution of charge/discharge command values. For example, reference data including a reference distribution that is consistent with the distribution of charge/discharge command values (i.e. a distance to the distribution is zero) or reference data including a reference distribution whose distance to the distribution of the charge/discharge command values is less than a threshold is detected.

The SoH estimator 13 specifies reference data (object reference data) to be used in deterioration evaluation based on power distribution information (or a deterioration feature) in a similar manner to the first embodiment from among the pieces of detected reference data. In addition, the second information (reference OCV gradient) representing a reference change of a voltage value with respect to a charge amount is acquired based on the object reference data. In other words, the second information (reference OCV gradient) representing a reference change of a voltage value with respect to a charge amount is acquired based on the power distribution information.

In addition, in a similar manner to the first embodiment, reference data (object reference data) may be specified by further using a representative temperature of the rechargeable battery 201. Furthermore, the second information (reference OCV gradient) representing a reference change of a voltage value with respect to a charge amount is acquired based on the object reference data. In other words, the second information (reference OCV gradient) representing a reference change of a voltage value with respect to a charge amount is acquired based on the representative temperature.

Depending on a value of power indicated by a charge/discharge command value, a value of voltage (charge voltage or discharge voltage) of a rechargeable battery is affected. In other words, depending on a distribution of charge/discharge command values, a distribution of voltage measured from a rechargeable battery is affected. Therefore, by using reference data of a sample rechargeable battery whose voltage distribution has been calculated with charge/discharge command values of a distribution similar to the distribution of charge/discharge command values of the rechargeable battery 201, more suitable training data (reference data) can be used. Accordingly, estimation of a SoH of the rechargeable battery 201 can be performed with higher accuracy.

(Third modification)

Even in the second modification described above, a SoH prior to correction of the rechargeable battery 201 can be calculated using an evaluation function in a similar manner to the first modification. In doing so, a plurality of distributions of charge/discharge command values are prepared for selecting an evaluation function and an evaluation function is created for each distribution of the charge/discharge command values for evaluation function selection. An evaluation function is stored in the reference DB 16 in association with each distribution. An evaluation function may be created for every plurality of temperatures with respect to each distribution. In this case, an evaluation function is stored in the reference DB 16 in association with each set of a distribution and a temperatu re.

The SoH estimator 13 selects an evaluation function corresponding to a distribution that is consistent with or closest to the distribution of charge/discharge command values of the rechargeable battery 201 from the reference DB 16. The SoH estimator 13 calculates a SoH prior to correction (a SoH that only assumes cycle deterioration) using the selected evaluation function, a deterioration feature of the rechargeable battery 201, and the like. Alternatively, the SoH estimator 13 selects an evaluation function associated with a distribution and a temperature that are consistent with or closest to a set of a distribution of charge/discharge command values and a representative temperature of the rechargeable battery 201 from the reference DB 16. The SoH estimator 13 calculates a SoH prior to correction using the selected evaluation function, a deterioration feature of the rechargeable battery 201, and the like.

(Hardware configuration)

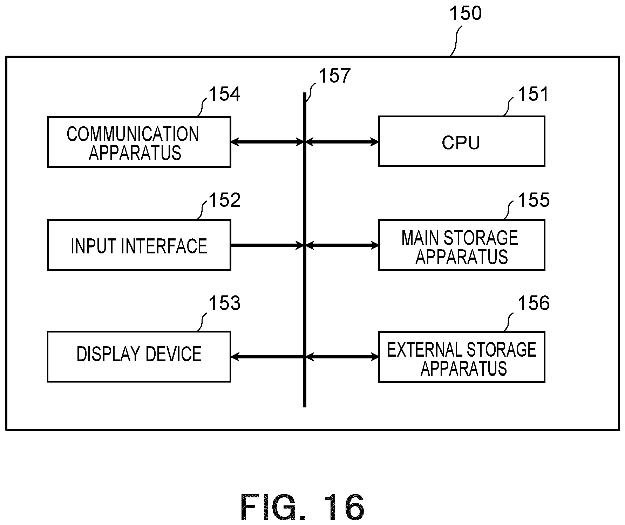

FIG. 16 shows a hardware configuration example of the rechargeable battery evaluation apparatus according to an embodiment of the present invention. The hardware configuration can be used in the rechargeable battery evaluation apparatus according to the embodiment of the present invention. The hardware configuration shown in FIG. 16 is constructed as a computer 150. The computer 150 includes a CPU 151, an input interface 152, a display device 153, a communication apparatus 154, a main storage apparatus 155, and an external storage apparatus 156 which are connected by a bus 157 so as to be mutually communicable.

The input interface 152 acquires measured data having been measured in a rechargeable battery via wiring or the like. The input interface 152 may be an operation device used by the user to give instructions to the present apparatus. Examples of the operation device include a keyboard, a mouse, and a touch panel. The communication apparatus 154 includes a wireless or wired communication device and performs wired or wireless communication with the rechargeable battery 201 and the monitoring system 301. Measured data may be acquired via the communication apparatus 154. The input interface 152 and the communication apparatus 154 may be respectively constituted by a separate circuit such as an integrated circuit or may be constituted by a single circuit such as an integrated circuit. The display device 153 is, for example, a liquid crystal display device, an organic EL display device, or a CRT display device.

For example, the external storage apparatus 156 includes a storage medium or the like such as an HDD, an SSD, a memory device, a CD-R, a CD-RW, a DVD-RAM, or a DVD-R. The external storage apparatus 156 stores a program for causing the CPU 151 that is a processor to execute functions of the respective processing devices of the rechargeable battery evaluation apparatus. In addition, each DB included in the rechargeable battery evaluation apparatus is also included in the external storage apparatus 156. While only one external storage apparatus 156 is shown, the external storage apparatus 156 may be present in plurality.

**EP 4 287 451 A1**

Under the control of the CPU 151, the main storage apparatus 155 deploys a control program stored in the external storage apparatus 156 and stores data necessary for executing the program, data created by executing the program, and the like. The main storage apparatus 155 includes any memory or storage such as a volatile memory (a DRAM, an SRAM, or the like) or a non-volatile memory (a NAND flash memory, an MRAM, or the like). Due to the execution by the CPU 151 of the control program deployed in the main storage apparatus 155, functions of the respective processing devices of the rechargeable battery evaluation apparatus 101 are executed.

While certain arrangements have been described, these arrangements have been presented by way of example only, and are not intended to limit the scope of the inventions. Indeed, the apparatuses* described herein may be embodied in a variety of other forms; furthermore various omissions, substitutions and changes in the form of the apparatuses described herein may be made.

[Reference Signs List]

| | |
|---|---|
| 1 | rechargeable battery evaluation system |
| 1A | rechargeable battery evaluation system |
| 11 | data input device |
| 12 | charge/discharge information DB |
| 13 | SoH estimator |
| 14 | voltage distribution calculator |
| 15 | representative temperature calculator |
| 16 | reference DB |
| 17 | deterioration feature calculator |
| 18 | OCV calculator |
| 19 | comparator |
| 20 | SoH corrector |
| 21 | SoH output device |
| 22 | power distribution calculator |
| 31 | battery unit |
| 32 | battery module |
| 34 | cell |
| 101 | rechargeable battery evaluation apparatus |
| 101 | battery energy storage system |
| 101A | rechargeable battery evaluation apparatus |
| 150 | computer |
| 152 | input interface |
| 153 | display device |
| 154 | communication apparatus |
| 155 | main storage apparatus |
| 156 | external storage apparatus |
| 157 | bus |
| 201 | rechargeable battery |
| 202 | rechargeable battery |
| 301 | monitoring system |
| 301 | control system |

**Claims**

1. An information processing apparatus, comprising:

    an information calculator configured to calculate, based on measured data of a voltage value and a charge amount of a rechargeable battery which is controlled for charge/discharge according to a charge/discharge command value, first information indicating a change of the voltage value with respect to the charge amount; and
    a state estimator configured to acquire second information indicating a reference change of a voltage value with respect to a charge amount in accordance with a range of the voltage values in the measured data and estimate a state of the rechargeable battery based on the first information and the second information.

13

2. The information processing apparatus according to claim 1, wherein
the state estimator is configured to estimate a state of the rechargeable battery based on a comparison between the first information and the second information.

3. The information processing apparatus according to claim 2, wherein
the state estimator is configured to determine that the larger the change indicated by the first information as compared to the change indicated by the second information, the more progressed at least one of float deterioration and storage deterioration is in the rechargeable battery.

4. The information processing apparatus according to any one of claims 1 to 3, wherein

the state estimator is configured to determine a reference state of the rechargeable battery in accordance with a range of the voltage value,
the state estimator is configured to determine a reference range of the charge amount in accordance with a range of the voltage value in the measured data, the information processing apparatus comprises
a corrector configured to correct information indicating the reference state in accordance with a ratio or a difference between a size of the range of the charge amount in the measured data and a size of the reference range of the charge amount, and
the state estimator is configured to determine a state of the rechargeable battery based on the corrected information.

5. The information processing apparatus according to claim 4, wherein
the size of the range of the charge amount is a difference between a minimum value and a maximum value of the charge amount or a difference between a charge amount corresponding to the voltage value being a maximum voltage value and a charge amount corresponding to the voltage value being a minimum voltage value.

6. The information processing apparatus according to any one of claims 1 to 3, wherein

the state estimator is configured to determine a state to be reference of the rechargeable battery in accordance with a range of the voltage value in the measured data, the information processing apparatus comprises
a corrector configured to correct information indicating the reference state in accordance with a ratio or a difference between the first information and the second information, and
the state estimator is configured to determine a state of the rechargeable battery based on the corrected information.

7. The information processing apparatus according to any one of claims 4 to 6, comprising

a feature calculator configured to calculate a feature related to a range of the voltage value based on the measured data, and
the state estimator is configured to determine a reference state of the rechargeable battery based on the feature.

8. The information processing apparatus according to any one of claims 4 to 7, wherein
the reference state of the rechargeable battery is a state where the rechargeable battery is assumed to include cycle deterioration and not to include float deterioration and storage deterioration.

9. The information processing apparatus according to any one of claims 1 to 8, wherein
the state estimator is configured to select the second information in accordance with a range of the voltage value in the measured data from among a plurality of pieces of the second information corresponding to a plurality of ranges of the voltage value.

10. The information processing apparatus according to any one of claims 1 to 9, wherein
the information calculator is configured to generate a function or a graph that represents a relationship between the charge amount and the voltage value, and the first information represents a gradient of the function or the graph.

11. The information processing apparatus according to claim 10, wherein
the information calculator is configured to estimate an OCV of the rechargeable battery based on the measured data, and the function represents a relationship between the charge amount and the OCV.

**12.** The information processing apparatus according to any one of claims 1 to 11, wherein
the range of the voltage value is a standard deviation of the voltage value or a difference between a maximum value and a minimum value of the voltage value.

**13.** The information processing apparatus according to any one of claims 1 to 12, wherein
the state estimator is configured to determine the second information further based on a distribution of the charge/discharge command value.

**14.** The information processing apparatus according to any one of claims 1 to 13, wherein

the measured data includes a temperature of the rechargeable battery, the information processing apparatus comprises
a representative temperature determiner configured to determine a representative temperature of the rechargeable battery based on the temperature in the measured data, and
the state estimator is configured to determine the second information further based on the representative temperature.

**15.** The information processing apparatus according to any one of claims 1 to 14, wherein
the state of the rechargeable battery is a degree of soundness or a deterioration state of the rechargeable battery.

**16.** An information processing method, comprising:

calculating, based on measured data of a voltage value and a charge amount of a rechargeable battery which is controlled for charge/discharge according to a charge/discharge command value, first information indicating a change of the voltage value with respect to the charge amount;
acquiring second information indicating a reference change of a voltage value with respect to a charge amount in accordance with a range of the voltage values in the measured data; and
estimating a state of the rechargeable battery based on the first information and the second information.

**17.** A computer program which causes a computer to perform processes, comprising:

calculating, based on measured data of a voltage value and a charge amount of a rechargeable battery which is controlled for charge/discharge according to a charge/discharge command value, first information indicating a change of the voltage value with respect to the charge amount;
acquiring second information indicating a reference change of a voltage value with respect to a charge amount in accordance with a range of the voltage values in the measured data; and
estimating a state of the rechargeable battery based on the first information and the second information.

**18.** An information processing system, comprising:

a rechargeable battery which is controlled for charge/discharge according to a charge/discharge command value; and
an information calculator configured to calculate, based on measured data of a voltage value and a charge amount of the rechargeable battery, first information indicating a change of the voltage value with respect to the charge amount, a state estimator configured to acquire second information indicating a reference change of a voltage value with respect to a charge amount in accordance with a range of the voltage values in the measured data and estimate a state of the rechargeable battery based on the first information and the second information.

1

RECHARGEABLE
BATTERY 201

MONITORING
SYSTEM 301

101

11

DATA INPUT
DEVICE

CHARGE/DISCHARGE
INFORMATION DB 12

SoH ESTIMATOR 13

SoH OUTPUT
DEVICE 21

REPRESENTATIVE
TEMPERATURE
CALCULATOR

VOLTAGE
DISTRIBUTION
CALCULATOR 14

REFERENCE DB 16

15

DETERIORATION
FEATURE
CALCULATOR

OCV CALCULATOR
(INFORMATION
CALCULATOR)

OCV GRADIENT
COMPARATOR

SoH
CORRECTOR

17

18

19

20

FIG. 1

FIG. 2

FIG. 3

| TIME OF DAY | CHARGE/DISCHARGE COMMAND VALUE (POWER)[kW] | CHARGE AMOUNT (SoC) | VOLTAGE [V] | TEMPERATURE [°C] |
|---|---|---|---|---|
| t1 | P1 | Q1 | V1 | T1 |
| t2 | P2 | Q2 | V2 | T2 |
| t3 | P3 | Q3 | V3 | T3 |
| … | … | … | … | … |
| ti | Pi | Qi | Vi | Ti |
| … | … | … | … | … |
| tj | Pj | Qj | Vj | Tj |
| … | … | … | … | … |
| tn | Pn | Qn | Vn | Tn |

# FIG. 4

QV PLOT

FIG. 5

QV PLOT (GENERATED OCV)

<-- Vmax

SoC [%]

# FIG. 6

FIG. 7

QV PLOT (GENERATED OCV)

FIG. 8

QV PLOT

FIG. 9

| ID | DETERIORATION FEATURE | VOLTAGE DISTRIBUTION INFORMATION | REPRESENTATIVE TEMPERATURE | SoH (DETERIORATION STATE) |
|---|---|---|---|---|
| 1 | 1.8 | SET OF (SOC, V) | 23.5 | 68.1 |
| 2 | 2.1 | SET OF (SOC, V) | 26.2 | 68.9 |
| 3 | 2.2 | SET OF (SOC, V) | 29.0 | 68.6 |
| . . . | . . . | . . . | . . . | . . . |

# FIG. 10

FIG. 11

```
                    ┌─────────────────┐
                    │     START       │
                    └────────┬────────┘
                             │
          ┌──────────────────────────────────┐
          │    CALCULATE DETERIORATION        │
          │ FEATURE FROM VOLTAGE DISTRIBUTION │~S11
          │      BASED ON MEASURED DATA       │
          │    OF RECHARGEABLE BATTERY        │
          └──────────────────┬───────────────┘
                             │
          ┌──────────────────────────────────┐
          │    ACQUIRE REFERENCE DATA FROM    │
          │ REFERENCE DB BASED ON DETERIORATION│~S12
          │   FEATURE (OR VOLTAGE DISTRIBUTION) │
          └──────────────────┬───────────────┘
                             │
          ┌──────────────────────────────────┐
          │    GENERATE GENERATED OCV GRAPH   │
          │ OF RECHARGEABLE BATTERY AND CALCULATE│~S13
          │   GRADIENT OF GENERATED OCV GRAPH │
          └──────────────────┬───────────────┘
                             │
                    ◇─────────────◇  S14
                   GRADIENT OF
               GENERATED OCV GRAPH >         NO
               GRADIENT OF GENERATED OCV ─────────────┐
                GRAPH TO BE REFERENCE                 │
                    ◇─────────────◇                   │
                        │ YES                         │
```

S18 ~ DETERMINE THAT THERE IS FLOAT DETERIORATION/STORAGE DETERIORATION

DETERMINE THAT THERE IS NO FLOAT DETERIORATION/STORAGE DETERIORATION ~S15

S19 ~ CALCULATE GRADIENT RATIO (SOC WIDTH RATIO)

DETERMINE SoH OF REFERENCE DATA TO BE SoH OF RECHARGEABLE BATTERY THAT IS EVALUATION OBJECT ~S16

S20 ~ CORRECT SoH OF REFERENCE DATA IN ACCORDANCE WITH GRADIENT RATIO (SOC WIDTH RATIO)

OUTPUT SoHN ~S17

S21 ~ OUTPUT SoH REFLECTING FLOAT DETERIORATION/STORAGE DETERIORATION

```
                    ┌─────────────────┐
                    │      END        │
                    └─────────────────┘
```

FIG. 12

1A

201
RECHARGEABLE BATTERY

301
MONITORING SYSTEM

101A

11
DATA INPUT DEVICE

12
CHARGE/DISCHARGE INFORMATION DB

13
SoH ESTIMATOR

21
SoH OUTPUT DEVICE

22
POWER DISTRIBUTION CALCULATOR

15
REPRESENTATIVE TEMPERATURE CALCULATOR

14
VOLTAGE DISTRIBUTION CALCULATOR

16
REFERENCE DB

17
DETERIORATION FEATURE CALCULATOR

18
OCV CALCULATOR (INFORMATION CALCULATOR)

19
OCV GRADIENT COMPARATOR

20
SoH CORRECTOR

## FIG. 13

FIG. 14

| ID | REFERENCE DISTRIBUTION OF CHARGE/DISCHARGE COMMAND VALUES | VOLTAGE FEATURE | VOLTAGE DISTRIBUTION INFORMATION | REPRESENTATIVE TEMPERATURE | SoH (DETERIORATION STATE) |
|---|---|---|---|---|---|
| 1 | | 1.8 | SET OF (SOC, V) | 23.5 | 68.1 |
| 2 | | 2.1 | SET OF (SOC, V) | 26.2 | 68.9 |
| 3 | | 2.2 | SET OF (SOC, V) | 29.0 | 68.6 |
| . . . | | . . . | . . . | . . . | . . . |

# FIG. 15

150

| 154 | 157 | 151 |
|---|---|---|
| COMMUNICATION APPARATUS | ↔ | CPU |
| 152 | | 155 |
| INPUT INTERFACE | ↔ | MAIN STORAGE APPARATUS |
| 153 | | 156 |
| DISPLAY DEVICE | ↔ | EXTERNAL STORAGE APPARATUS |

# FIG. 16

## INTERNATIONAL SEARCH REPORT

International application No.

**PCT/JP2022/013120**

### A. CLASSIFICATION OF SUBJECT MATTER

*H02J 7/00*(2006.01)i; *H01M 10/48*(2006.01)i
FI:  H02J7/00 Y; H01M10/48 P

According to International Patent Classification (IPC) or to both national classification and IPC

### B. FIELDS SEARCHED

Minimum documentation searched (classification system followed by classification symbols)

H02J7/00; H01M10/48

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2013-225441 A (HITACHI, LTD.) 31 October 2013 (2013-10-31)<br>entire text, all drawings | 1-18 |
| A | JP 2020-119712 A (TOSHIBA CORP.) 06 August 2020 (2020-08-06)<br>entire text, all drawings | 1-18 |
| A | JP 2017-194468 A (TOSHIBA CORP.) 26 October 2017 (2017-10-26)<br>entire text, all drawings | 1-18 |
| A | JP 2022-11803 A (DENSO CORP.) 17 January 2022 (2022-01-17)<br>entire text, all drawings | 1-18 |
| A | JP 2021-27031 A (DENSO CORP.) 22 February 2021 (2021-02-22)<br>entire text, all drawings | 1-18 |
| A | JP 2022-11801 A (DENSO CORP.) 17 January 2022 (2022-01-17)<br>entire text, all drawings | 1-18 |

☐ Further documents are listed in the continuation of Box C.      ☑ See patent family annex.

| | |
|---|---|
| *     Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **02 June 2022** | **14 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/013120**

| Patent document cited in search report | | | Publication date (day/month/year) | Patent family member(s) | | | Publication date (day/month/year) |
|---|---|---|---|---|---|---|---|
| JP | 2013-225441 | A | 31 October 2013 | US entire text, all drawings WO | 2015/0046109 2013/161540 | A1 A1 | |
| JP | 2020-119712 | A | 06 August 2020 | US entire text, all drawings | 2020/0233037 | A1 | |
| JP | 2017-194468 | A | 26 October 2017 | US entire text, all drawings WO EP KR CN CA | 2017/0031404 2017/022037 3330726 10-2017-0035825 106796267 2993505 | A1 A1 A1 A A A1 | |
| JP | 2022-11803 | A | 17 January 2022 | (Family: none) | | | |
| JP | 2021-27031 | A | 22 February 2021 | WO | 2021/020250 | A1 | |
| JP | 2022-11801 | A | 17 January 2022 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6313502 B
- JP 6759466 B
- JP 2020119712 A